# EUROPÄISCHE PATENTSCHRIFT

(11) **EP 2 737 327 B1**
(45) Veröffentlichungstag und Bekanntmachung des Hinweises auf die Patenterteilung: **12.09.2018**
(21) Anmeldenummer: 12745439.5
(22) Anmeldetag: 26.07.2012
(51) Int. Cl.: G01R 19/00, G01R 31/36, G01R 1/20, B60R 16/033, H02G 3/18, H05K 13/00

(54) **SCHALTUNG ZUM LEITEN EINES ELEKTRISCHEN STROMES**
CIRCUIT FOR CONDUCTING AN ELECTRICAL CURRENT
CIRCUIT POUR CONDUIRE UN COURANT ÉLECTRIQUE

(30) Priorität: 28.07.2011 DE 102011079966
(43) Veröffentlichungstag der Anmeldung: 04.06.2014
(73) Patentinhaber: Continental Teves AG & Co. oHG, 60488 Frankfurt (DE)
(72) Erfinder: HAVERKAMP, Martin, 60385 Frankfurt (DE); JÖCKEL, Wolfgang, 36129 Gersfeld (DE); HERCHENRÖDER, Jens, 63636 Brachttal-Udenhain (DE); RINK, Klaus, Rodenbach 63517 (DE); ECKRICH, Jörg, 65201 Wiesbaden (DE)
(86) Internationale Anmeldenummer: PCT/EP2012/064713
(87) Internationale Veröffentlichungsnummer: WO 2013/014242

(56) Entgegenhaltungen:
- DE-A1- 10 118 027
- DE-A1- 10 357 524
- DE-A1- 19 736 025
- DE-A1-102004 007 851
- DE-A1-102005 043 320
- DE-A1-102011 078 548
- DE-U1- 20 318 266
- FR-A1- 2 879 751
- FR-A1- 2 910 719
- GB-A- 2 441 211
- JP-A- 2009 236 641
- US-A1- 2008 238 431
- US-A1- 2010 316 901
- US-B1- 6 304 062

## Beschreibung

Die Erfindung betrifft eine Fahrzeugbatterieschaltung zum Leiten eines elektrischen Stromes zwischen einer Fahrzeugbatterie und einer an die Fahrzeugbatterie anschließbaren elektrischen Netzwerkkomponente über einen Stromsensor sowie eine Fahrzeugbatterie mit der Fahrzeugbatterieschaltung.

Zur Durchführung von Messungen eines von einer elektrischen Energiequelle an einen elektrischen Verbraucher abgegebenen elektrischen Stromes in einem Kraftfahrzeug können in Reihe zwischen die elektrische Energiequelle und den elektrischen Verbraucher ein Stromsensor geschaltet werden. Ein derartiger Stromsensor ist beispielsweise aus der DE 10 2011 078 548 A1 bekannt.

Stromsensoren müssen elektrisch in Reihe zwischen die elektrische Energiequelle und den elektrischen Verbraucher geschalten werden. Batterieschaltungen mit Stromsensoren sind auch aus DE 10 2004 007 851 A1, DE 10 2005 043 320 A1, DE 197 36 025 A1, US 6,304,062 B1, US 2008/238431 A1, JP 2009 236641 A, FR 2 879 751 A1 sowie US 2010/316901 A1 bekannt.

Es ist Aufgabe der vorliegenden Erfindung diese Schaltung der Stromsensoren in Reihe zwischen Energiequelle und Verbraucher zu verbessern.

Die Aufgabe wird durch die Merkmale der unabhängigen Ansprüche gelöst. Bevorzugte Weiterbildungen sind Gegenstand der abhängigen Ansprüche.

Die Erfindung schlägt eine Fahrzeugbatterieschaltung zum Leiten eines elektrischen Stromes zwischen einer Fahrzeugbatterie und einer an die Fahrzeugbatterie anschließbaren elektrischen Netzwerkkomponente über einen Stromsensor vor, die folgende Merkmale umfasst:
- einen ersten flächenförmig verlaufenden elektrischen Leitungsabschnitt zum elektrischen Kontaktieren mit einem Pol der Fahrzeugbatterie,
- einen vom ersten Leitungsabschnitt getrennten zweiten flächenförmig verlaufenden elektrischen Leitungsabschnitt zum elektrischen Kontaktieren mit der elektrischen Netzwerkkomponente, und
- den Stromsensor, der die Leitungsabschnitte miteinander elektrisch verbindendet,
- wobei der Stromsensor außerhalb des flächenförmigen Verlaufs wenigstens einer der Leitungsabschnitte angeordnet ist.

Die elektrische Netzwerkkomponente kann neben der Fahrzeugbatterie jedes beliebige elektrische Bauelement wie eine elektrische Energiequelle in Form eines Generators, einer Steckdose oder einer weiteren Batterie oder ein elektrischer Verbraucher, wie beispielsweise ein elektrisches Fahrzeugboardnetz oder ein Elektromotor sein.

Der angegebenen Schaltung liegt die Überlegung zugrunde, dass der Stromsensor direkt zwischen die Fahrzeugbatterie und die elektrische Netzwerkkomponente geschaltet werden könnte. Dieser Überlegung liegt jedoch die Erkenntnis zugrunde, dass die resultierende elektrische Verbindung gleichzeitig auch die mechanische Festigkeit zwischen der Fahrzeugbatterie und der elektrischen Netzwerkkomponente übernehmen müsste. Daher wird mit der angegebenen Schaltung vorgeschlagen, das den Stromsensor zwischen die Fahrzeugbatterie und die andere elektrische Netzwerkkomponente über Leitungsabschnitte elektrisch so miteinander zu kontaktieren, dass der Stromsensor aus einer mechanischen Stoßrichtung der Leitungsabschnitte herausgenommen ist. Dies wird in der vorliegenden Erfindung dadurch erreicht, dass der Stromsensor außerhalb des flächenförmigen Verlaufs wenigstens einer der Leitungsabschnitte angeordnet ist. Mit anderen Worten sind der Stromsensor und der wenigstens eine Leitungsabschnitt damit in zwei verschiedenen Ebenen angeordnet. Wenn damit eine Kraft, beispielsweise durch Wärmeausdehnung, in den flächenförmigen Verlauf des entsprechenden Leitungsabschnitts eingeleitet wird, so dass eine Kraftwirkungslinie dieser Kraft quer durch den Leitungsabschnitt geführt ist, dann liegt der Stromsensor außerhalb dieser Kraftwirkungslinie, so dass in den Stromsensor keine mechanischen Stoßkräfte aus dem Leitungsabschnitt eingeleitet werden können.

Auf diese Weise können mechanische Belastungen, beispielsweise durch Wärmearbeit, Erschütterungen oder andere mechanische Störungen auf den Stromsensor reduziert werden, so dass die elektrische Verbindung zwischen den Leitungsabschnitten und dem elektrischen Bauelement vor mechanischen Belastungen und damit vor mechanischen Spannungen geschützt ist.

Durch die angegebene Fahrzeugbatterieschaltung wird der Stromsensor zwischen der Fahrzeugbatterie und der anderen elektrischen Netzwerkkomponente dauerhaft und beständig elektrisch verschaltet, wodurch die elektrische Verbindung der Fahrzeugbatterie und der anderen elektrischen Netzwerkkomponente zuverlässiger ausgebildet werden kann. Gemäß der Erfindung umfasst die angegebene Fahrzeugbatterieschaltung eine Leiterplatte mit Messleiterbahnen, die den Stromsensor mit einer Auswerteschaltung elektrisch verbinden. Auswerteschaltung kann auf dieser Leiterplatte oder auf einer gesonderten Leiterplatte angeordnet sein. Die Messleiterbahnen selbst können mit dem Stromsensor selbst kontaktiert sein, um die zur Auswertung der Strommessung notwendigen Messsignale zwischen dem Stromsensor und der Auswerteschaltung zu transportieren. Bei einem passiven Shunt muss der Stromsensor beispielsweise an zwei verschiedenen Stellen elektrisch mit den Messleiterbahnen kontaktiert werden, um anhand eines Spannungsabfalles über dem passiven Shunt auf den elektrischen Strom zu schließen. Bei dem Stromsensor der eingangs genannten Art ist neben den Messleiterbahnen zur Erfassung des Spannungsabfalls noch zusätzlich eine als Steuerleitung ausgebildete Messleiterbahn notwendig, wozu auf die eingangs genannte Druckschrift verwiesen wird.

In einer zusätzlichen Weiterbildung der angegebenen Fahrzeugbatterieschaltung ist die Leiterplatte an den Leitungsabschnitten über eine mechanische Verbindung gehalten. Auf diese Weise ist die Leiterplatte mit den Messleiterbahnen mechanisch fest mit den Leitungsabschnitten verbunden, so dass für eine elektrische Verbindung zur Erfassung des Spannungsabfalls über dem Stromsensor mittels der Messleiterbahnen ein ausreichender mechanischer Halt vorhanden ist.

In einer bevorzugten Weiterbildung der angegebenen Fahrzeugbatterieschaltung ist die mechanische Verbindung über den Stromsensor geführt, so dass der Stromsensor neben seiner Hauptaufgabe, den elektrischen Strom von und zur Batterie zu messen zusätzlich auch zur mechanischen Stabilisierung der Leiterplatte verwendet wird.

Gemäß der Erfindung umfasst die angegebene Fahrzeugbatterieschaltung Stromführleiterbahnen, die den Stromsensor mit den Leitungsabschnitten elektrisch kontaktieren. Die Stromführleiterbahnen können dabei beliebig ausgeführt sein. Beispielsweise können die Stromführleiterbahnen Drähte oder feste Metallelemente sein, die zwischen den Stromsensor und die Leitungsabschnitte geschaltet werden. Andererseits werden gemäß der Erfindung Stromführleiterbahnen durch die Leiterplatte geführt, die als Hochstromleiterplatte ausgebildet ist. In einer besonderen Weiterbildung der angegebenen Fahrzeugbatterieschaltung sind die Stromführleiterbahnen und/oder die Messleiterbahnen an den Leitungsabschnitten über die mechanische Verbindung gehalten. Da die beiden Leitungsabschnitte prinzipbedingt voneinander getrennt sein müssen, übernimmt die Leiterplatte auf diese Weise die Funktion eines Abstandshalters, der die eingangs genannten mechanischen Kräfte auf die Leitungsabschnitte aufnimmt und so den Abstand zwischen den beiden Leitungsabschnitte aufrecht erhält.

In einer bevorzugten Weiterbildung der angegebenen Fahrzeugbatterieschaltung ist die mechanische Verbindung eine PressFit-Verbindung, eine Schraubverbindung, eine Lötverbindung, eine Leitklebverbindung und/oder eine Schweißverbindung. Über derartige Verbindungen können gleichzeitig elektrische und mechanische Kontaktierungen durchgeführt werden.

In einer besonders bevorzugten Weiterbildung umfasst die angegebene Fahrzeugbatterieschaltung einen Trägerrahmen, in dem die Stromführleiterbahnen gehalten sind. Durch den Trägerrahmen können die Stromführleiterbahnen mechanisch stabilisiert werden, die wie bereits erwähnt zur Strommessung prinzipbedingt getrennt sein müssen.

Die Erfindung gibt auch eine Fahrzeugbatterie an, die folgende Elemente umfasst:
- einen elektrischen Anschluss zum Abgeben oder Aufnehmen eines elektrischen Stromes an einen elektrischen Verbraucher beziehungsweise von einer elektrischen Energiequelle, und
- eine der angegebenen Fahrzeugbatterieschaltungen, die mit einem ihrer elektrischen Leitungsabschnitte an den elektrischen Anschluss angeschlossen ist.

Die Erfindung gibt auch ein Fahrzeug an, das
- eine Fahrzeugbatterie,
- eine an die Fahrzeugbatterie angeschlossene elektrische Netzwerkkomponente und
- eine der angegebenen Schaltungen umfasst, die zwischen die Fahrzeugbatterie und die elektrische Netzwerkkomponente geschaltet ist.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:
Fig. 1 eine schematische Ansicht einer an einen Fahrzeugbatteriepol angeschlossene Fahrzeugbatterieschaltung mit zwei Stromsensoren;
Fig. 2 eine schematische Ansicht eines Regelkreises zur Steuerung des Stromsensors aus Fig. 1;
Fig. 3 eine perspektivische Ansicht einer Fahrzeugbatterieschaltung gemäß einer ersten Ausführung;
Fig. 4 eine perspektivische Ansicht eines Stromsensors aus der Fahrzeugbatterieschaltung der Fig. 3;
Fig. 5 eine perspektivische Ansicht einer Fahrzeugbatterieschaltung gemäß einer zweiten Ausführung;
Fig. 6 eine perspektivische Ansicht eines Stromsensors aus der Fahrzeugbatterieschaltung der Fig. 5;
Fig. 7 eine perspektivische Ansicht einer Fahrzeugbatterieschaltung gemäß einer dritten Ausführung;
Fig. 8 eine perspektivische Ansicht eines Stromsensors aus der Fahrzeugbatterieschaltung der Fig. 7;
Fig. 9 eine perspektivische Ansicht eines alternativen Stromsensors aus der Fahrzeugbatterieschaltung der Fig. 7;
Fig. 10 eine perspektivische Ansicht einer Fahrzeugbatterieschaltung gemäß einer vierten Ausführung;
Fig. 11 eine perspektivische Ansicht eines Stromsensors aus der Fahrzeugbatterieschaltung der Fig. 10;
Fig. 12 eine perspektivische Ansicht einer Fahrzeugbatterieschaltung gemäß einer fünften Ausführung;
Fig. 13 einen Ausschnitt aus der Darstellung gemäß Fig. 12;
Fig. 14 eine Seitenansicht der Fig. 13;
Fig. 15 eine perspektivische Ansicht eines Leitungsabschnittes mit einem darauf getragenen Stromsensor und einer auf dem Stromsensor getragenen Stromführleiterbahn der Fig. 12;
Fig. 16 eine perspektivische Ansicht einer Fahrzeugbatterieschaltung gemäß einer sechsten Ausführung;
Fig. 17 einen Ausschnitt aus der Darstellung gemäß Fig. 16;
Fig. 18 eine Seitenansicht der Fig. 17;
Fig. 19 eine perspektivische Ansicht eines Leitungsabschnittes mit einem darauf getragenen Stromsensor und einer auf dem Stromsensor getragenen Stromführleiterbahn der Fig. 16;
Fig. 20 eine perspektivische Ansicht einer Fahrzeugbatterieschaltung gemäß einer siebten Ausführung;
Fig. 21 eine perspektivische Ansicht einer Fahrzeugbatterieschaltung gemäß einer achten Ausführung;
Fig. 22 eine perspektivische Ansicht eines Stromsensors aus der Fahrzeugbatterieschaltung der Fig. 21;
Fig. 23 eine perspektivische Ansicht einer Fahrzeugbatterieschaltung gemäß einer neunten Ausführung;
Fig. 24 eine perspektivische Ansicht eines Stromsensors aus der Fahrzeugbatterieschaltung der Fig. 23;
Fig. 25 eine perspektivische Ansicht einer Fahrzeugbatterieschaltung gemäß einer zehnten Ausführung;
Fig. 26 eine perspektivische Ansicht eines Stromsensors aus der Fahrzeugbatterieschaltung der Fig. 25;
Fig. 27 eine perspektivische Ansicht einer Fahrzeugbatterieschaltung gemäß einer elften Ausführung; und
Fig. 28 eine perspektivische Ansicht eines Stromsensors aus der Fahrzeugbatterieschaltung der Fig. 27.

In den Figuren werden gleiche technische Elemente mit gleichen Bezugszeichen versehen und nur einmal beschrieben.

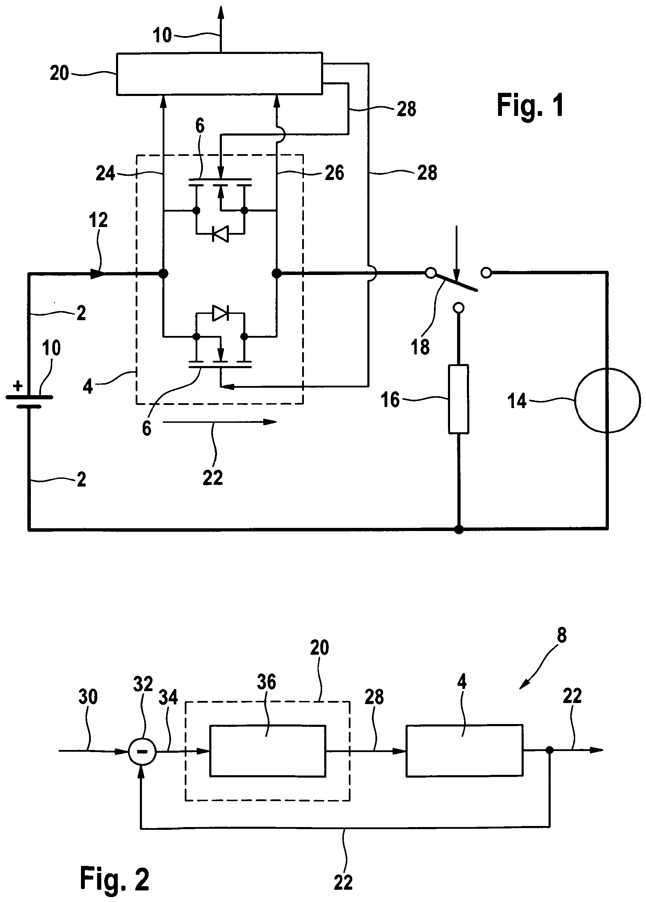

Es wird auf die Fig. 1 und 2 Bezug genommen, die entsprechend eine schematische Ansicht einer an einen Fahrzeugbatteriepol 2 angeschlossene Fahrzeugbatterieschaltung 4 mit zwei Stromsensoren 6 und eine schematische Ansicht eines Regelkreises 8 zur Steuerung der Stromsensoren 6 aus Fig. 1 zeigen.

Der Fahrzeugbatteriepol 2 ist einer von zwei Fahrzeugbatteriepolen 2 einer Fahrzeugbatterie 10. Über die Fahrzeugbatteriepol 2 und den an einen der Fahrzeugbatteriepole 2 angeschlossene Fahrzeugbatterieschaltung 4 kann ein elektrischer Strom 12 von einer elektrischen Energiequelle 14, wie beispielsweise einer Steckdose aufgenommen oder an einen elektrischen Verbraucher 16, wie beispielsweise einen Antriebsmotor eines nicht weiter dargestellten Fahrzeuges abgegeben werden.

Um den elektrischen Verbraucher 16 nicht direkt an die elektrische Energiequelle 14 anschließen zu können, können die elektrische Energiequelle 14 und der elektrische Verbraucher 16 zusätzlich über einen Umschalter 18 voneinander elektrisch getrennt sein, so dass abhängig von der Stellung des Umschalters 18 entweder die elektrische Energiequelle 14 oder der elektrische Verbraucher 16 an die Fahrzeugbatterie 10 angeschlossen ist.

Die Fahrzeugbatterieschaltung 4 mit den Stromsensoren 6 kann gemäß dem in der DE 10 2011 078 548 A1 offenbarten aktiven Shunt aufgebaut sein. Dazu weist jeder Stromsensor 6 in der vorliegenden Ausführung einen nicht näher referenzierten Feldeffekttransistor und eine nicht näher referenzierte Freilaufdiode auf, die in Durchlassrichtung von Source nach Drain verschaltet ist. Beide Stromsensoren 6 sind miteinander antiparallel zur Fahrzeugbatterieschaltung 4 verschaltet.

In Fig. 1 ist ferner eine Auswerteschaltung 20 gezeigt. Die Auswerteschaltung 20 kann Teil der Fahrzeugbatterieschaltung 4 oder als getrennte Schaltung ausgebildet sein. In der vorliegenden Ausführung ist die Fahrzeugbatterieschaltung 4 beispielhaft getrennt von der Auswerteschaltung 20 ausgebildet.

Die Auswerteschaltung 20 steuert in der vorliegenden Ausführung die Feldeffekttransistoren der Stromsensoren 6 derart, dass ein Spannungsabfall 22 über den Stromsensoren auf einem bestimmten Sollwert gehalten wird. Dazu empfängt die Auswerteschaltung 20 ein erstes elektrisches Potential 24, das von der Fahrzeugbatterie 10 aus gesehen vor den Stromsensoren 6 abgegriffen wird und ein zweites elektrisches Potential 26 das von der Fahrzeugbatterie 10 aus gesehen hinter den Stromsensoren 6 abgegriffen wird. Der Spannungsabfall 22 bestimmt sich aus der Differenz zwischen dem ersten elektrischen Potential 24 und dem zweiten elektrischen Potential 26.

Durch Ansteuern der Gates der Feldeffekttransistoren der Stromsensoren 6 mit je einem Steuersignal 28 für die Stromsensoren 6 wird der Spannungsabfall 22 über den in Fig. 2 gezeigten Regelkreis 8 auf dem Sollwert 30 gehalten. Die Steuersignale 28 sind, wie in der DE 10 2011 078 548 A1 gezeigt, abhängig vom zu messenden elektrischen Strom 12. Daher kann, wenn diese Abhängigkeit in der Auswerteschaltung 20 hinterlegt ist, der elektrische Strom 12 unmittelbar aus den Steuersignalen 28 abgeleitet werden.

Der Regelkreis 8 umfasst in der vorliegenden Ausführung als Regelstrecke die Fahrzeugbatterieschaltung 4, die über die Steuersignale 28 in der zuvor beschriebenen Weise angesteuert wird, so dass über den Stromsensoren 6 der Fahrzeugbatterieschaltung 4 der Spannungsabfall 20 abgegriffen werden kann. Dieser Spannungsabfall 2 wird an einem Differenzglied 32 dem Sollwert 30 durch Differenzbildung gegenübergestellt, wobei sich eine Regeldifferenz 34 ergibt, die an einen dem Fachmann bekannten und in der Auswerteschaltung 20 angeordneten Regler 36 ausgegeben wird. Der Regler 36 erzeugt dann wiederum die Steuersignale 28, um den Spannungsabfall 22 auf dem Sollwert 30 zu halten.

Weitere Details der Stromsensoren 6 beziehungsweise ihrer Auswerteschaltung 20 können der bereits genannten DE 10 2011 078 548 A1 entnommen werden.

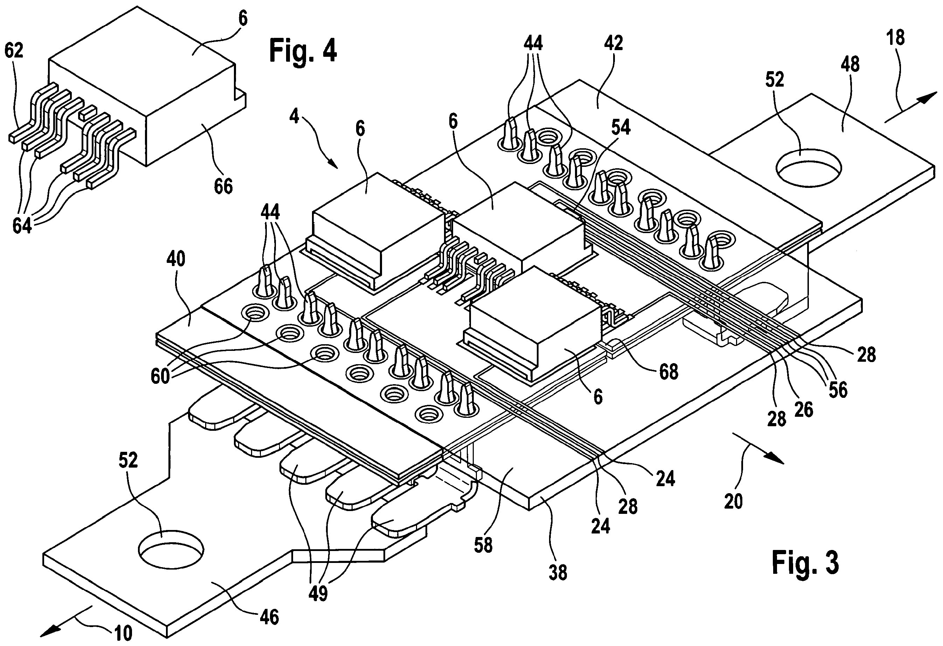

Es wird auf die Fig. 3 und 4 Bezug genommen, die entsprechend eine perspektivische Ansicht der Fahrzeugbatterieschaltung 4 gemäß einer ersten Ausführung und ihrer Stromsensoren 6 sowie eine Ausführung der Stromsensoren 6 selbst zeigen.

Die Stromsensoren 6 sind in der vorliegenden Ausführung au einer Leiterplatte 38 getragen, die als Hochstromleiterplatte ausgeführt ist. Unter einer Hochstromleiterplatte sollen nachstehend Leiterplatten verstanden werden, auf denen Hochstromleiterbahnen genauso angeordnet werden können wie Leiterbahnen aus der Fein- und Feinstleitertechnik.

Die Hochstromleiterplatte 38 durchdringen in der vorliegenden Ausführung zwei Stromführleiterbahnen 40, 42, die über PressFit-Pins 44 entsprechend mit Leitungsabschnitten 46, 48 elektrisch verbunden sind. Von den PressFit-Pins 44 sind in der vorliegenden Ausführung der Übersichtlichkeit halber nicht alle mit einem Bezugszeichen versehen. Die elektrische Kontaktierung an den Leitungsabschnitten 46, 48, erfolgt dabei über Schuhe 49, die mit den Leitungsabschnitten 46, 48 elektrisch leitend verklebt, verschweißt, verlötet oder in jeder beliebigen anderen Weise kontaktiert sein können. Von den Schuhen 49 sind in der vorliegenden Darstellung der Übersichtlichkeit halber nicht alle mit einem Bezugszeichen versehen.

Über die Leitungsabschnitte 46, 48 kann die Fahrzeugbatterieschaltung 4 mit der Fahrzeugbatterie 10 und den Umschalter 18 elektrisch verbunden werden. Nachstehend soll in die Zeichnungsebene hinein betrachtet der linke Leitungsabschnitt 46 als Leitungsabschnitt 46 als zur elektrischen Kontaktierung mit der Fahrzeugbatterie 10 und der rechte Leitungsabschnitt 48 als zur elektrischen Kontaktierung mit dem Umschalter 18 vorgesehen betrachtet werden. Zur elektrischen Verbindung weisen die Leitungsabschnitte 46, 48 je eine Durchgangsbohrung 52 auf, über die die Leitungsabschnitte 46, 48 beispielsweise verschraubt werden können.

Somit kann der elektrische Strom zwischen der Fahrzeugbatterie 10 und dem Umschalter 18 über die Leitungsabschnitte 46, 48, die Stromführleiterbahnen 40, 42 und die Stromsensoren 6 geführt werden. Diese Strom-Strecke sollte elektrisch so dimensioniert sein, dass sie Leistungsströme zwischen der Fahrzeugbatterie 10 und der elektrischen Energiequelle 14 beziehungsweise dem elektrischen Verbraucher 16 übertragen kann. Da die Dimensionierung einer derartigen Stromstrecke dem Fachmann bekannt ist, soll nachstehend nicht weiter darauf eingegangen werden.

Demgegenüber ist die Leistung von Signalen, die zur Auswerteschaltung 20 führen vergleichsweise niedrig. Zu diesen unter diese Signale fallen beispielsweise die Steuersignale 28 und die Signale zum Übertragen des ersten und zweiten Potentials 24, 26. Weiterhin ist auf der Hochstromleiterplatte ein Temperatursensor 54 angeordnet, der über zwei Leiterbahnen Temperatursignale 56 an die Auswerteschaltung 20 abgibt, damit diese bei der Strommessung die Temperaturentwicklung berücksichtigen kann, die auf den elektrischen Widerstand der oben genannten Strom-Strecke und damit auf den erfassten Strom Einfluss hat. Die zuvor genannten, zur Auswerteschaltung 20 geführten Signale sollen auf sogenannten Messleiterbahnen geführt werden, die nachstehen der Übersichtlichkeit halber nicht mit einem eigenen Bezugszeichen versehen werden, sondern mit dem Bezugszeichen, dessen Signal sie transportieren.

Die über die PressFit-Pins 44 mit den Leitungsabschnitten 46, 48 elektrisch kontaktierten Stromführleiterbahnen 40, 42 können in einem faserverstärktem Kunststoff 58 elektrisch isolierend eingebettet sein, wobei der faserverstärkte Kunststoff 58 über Kontaktierungsbohrungen 60 an den Stromführleiterbahnen 40, 42 mechanisch befestigt ist. Von den Kontaktierungsbohrungen 60 sind der Übersichtlichkeit halber nicht alle mit einem Bezugszeichen versehen.

Die Stromsensoren 6 sind in der vorliegenden Ausführung als integrierte Schaltungen ausgeführt, von denen in Fig. 4 ein Beispiel dargestellt ist. Die integrierte Schaltung weist Anschlüsse auf, zum Gate 62, zum Source 64 und zum Drain 66 des in der integrierten Schaltung gehaltenen und in Fig. 1 gezeigten Feldeffekttransistor führen. Durch den faserverstärken Kunststoff 58 hindurch sind von jeder integrierten Schaltung der Source-Anschluss 64 und der Drain-Anschluss 66 mit den Stromführleiterbahnen 40, 42 elektrisch kontaktiert, während der Gate-Anschluss 62 der integrierten Schaltungen nicht durch den mit dem Stromführleiterbahnen 40, 42 elektrisch kontaktiert werden sollte, da er ausschließlich von der Auswerteschaltung 20 aus angesteuert werden sollte.

Auf dem faserverstärkten Kunststoff 58 sind die oben erwähnten Messleiterbahnen getragen. Da es reicht, auf einer Stromführleiterbahn 40, 42 das Potential 24, 26 für den Spannungsabfall ein einer einzigen Stelle zu erfassen, werden die Potentiale 24, 26 in der vorliegenden Ausführung lediglich am Drain-Anschluss 66 der integrierten Schaltungen abgegriffen und über eine entsprechende Messleitung zur Auswerteschaltung 20 geführt. Vom Drain-Anschluss 64 der integrierten Schaltungen ist in der vorliegenden Ausführung keine eigene Messleiterbahn zur Auswerteschaltung 20 geführt, was jedoch rein exemplarisch zu verstehen ist.

Wenn sich aufgrund von Wärmeausdehnungen oder anderer mechanischer Einflüsse die beiden Leitungsabschnitte 46, 48 beispielsweise in Richtung ihrer Flächenausdehnung betrachtet relativ zueinander bewegen, so können entsprechende mechanische Spannungen durch die PressFit-Pins 44 aufgenommen werden, so dass eine Einleitung der mechanischen Spannungen in die Hochstromleiterplatte 38 und damit in die auf der Hochstromleiterplatte 38 getragenen elektrischen Komponenten vermieden wird. Zudem wird durch die Hochstromleiterplatte 38 und ihren faserverstärken Kunststoff 58 vermieden, dass ein für die Strommessung notwendiger mechanischer Spalt 68 zwischen den beiden Stromführleiterbahnen 40, 42 geschlossen und die Stromsensoren 6 elektrisch überbrückt werden. Dies sichert die elektrische Funktionalität der angegebenen Fahrzeugbatterieschaltung 4 dauerhaft und macht sie robust gegen äußere mechanische Einflüsse.

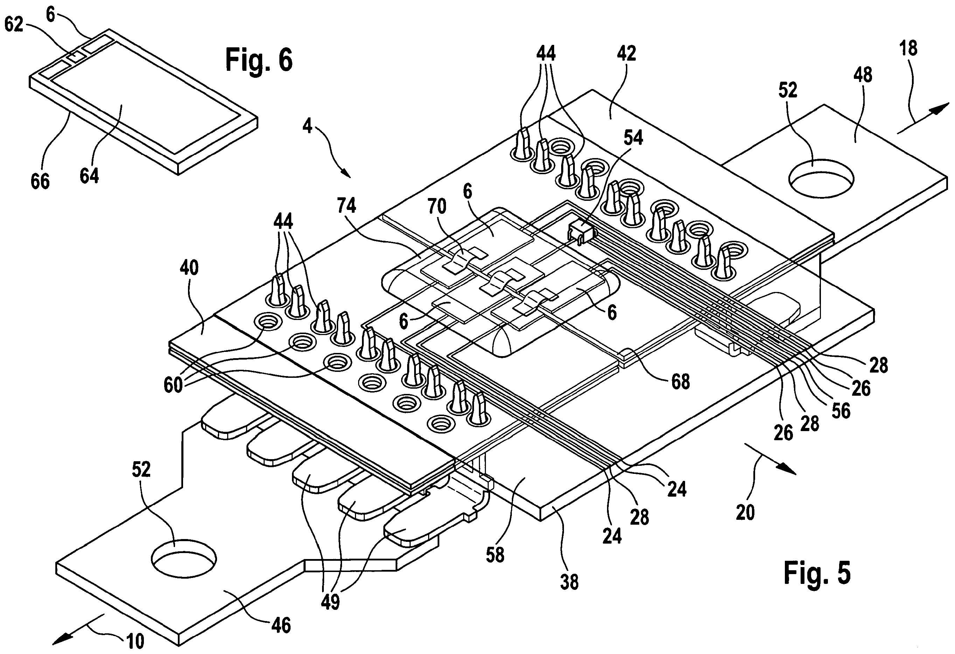

Es wird auf die Fig. 5 und 6 Bezug genommen, die entsprechend eine perspektivische Ansicht der Fahrzeugbatterieschaltung 4 gemäß einer zweiten Ausführung und ihrer Stromsensoren 6 sowie eine Ausführung der Stromsensoren 6 selbst zeigen.

In Fig. 5 und 6 sind die Stromsensoren 6 statt als integrierte Schaltung als Nacktchips ausgeführt, die dem Fachmann unter dem Begriff "bare dies" bekannt sind. Die Nacktchips weisen, wie in Fig. 6 gezeigt entsprechend den integrierten Schaltungen der Fig. 3 und 4 einen Gate-Anschluss 62, einen Source-Anschluss 64 und einen Drain-Anschluss 66 auf. In der vorliegenden Ausführungen wird im Gegensatz zu Fig. 3 jeder dieser Anschlüsse 62, 64, 66 mit einer eigenen Messleiterbahn angeschlossen und so mit der Auswerteschaltung 20 kontaktiert. Dies ist jedoch wieder beispielhaft zu sehen. Genauso gut könnte die Verschaltung analog zu Fig. 3 geschehen, oder die vorliegende Verschaltung könnte in Fig. 3 implementiert werden.

In der vorliegenden Ausführung ist der Drain-Anschluss 66 mit Bond-Bändern 70 elektrisch kontaktiert, die den mechanischen Spalt 68 zwischen den beiden Stromführleiterbahnen 40, 42 elektrisch überbrücken. Die Bond-D Bänder 70 sollten daher elektrisch ausreichend stromfest dimensioniert sein, um den gesamten Strom, der zwischen der Fahrzeugbatterie 10 und dem Umschalter 18 geleitet werden soll zu führen.

Zum Schutz der Nacktchips sowie der Bond-Bänder 70 beispielsweise vor Verschmutzung und Feuchtigkeit können diese mit einer Schutzmasse 74, wie beispielsweise einem Globe Top Schutz überdeckt werden.

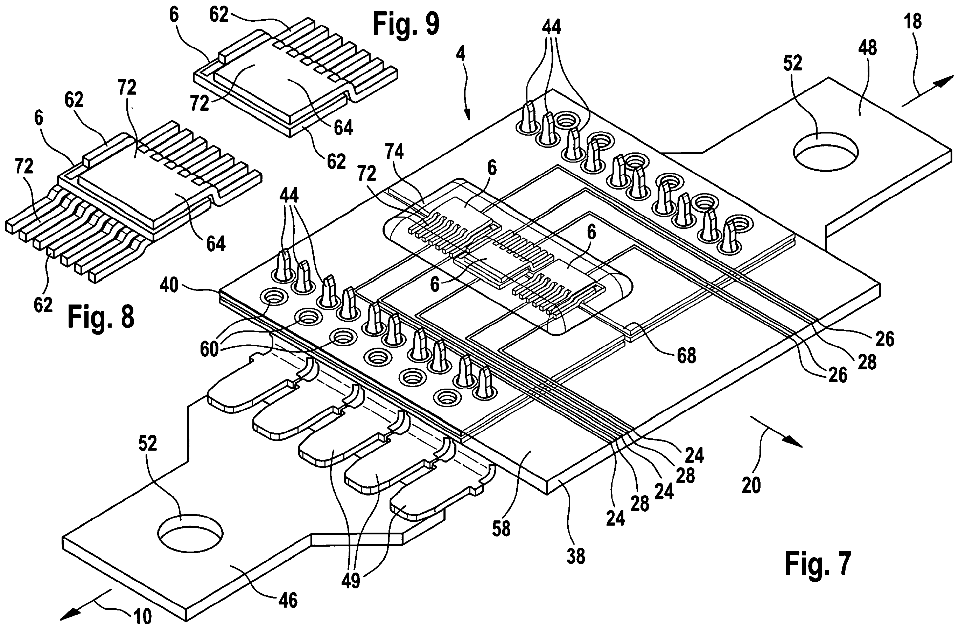

Es wird auf die Fig. 7 bis 9 Bezug genommen, die entsprechend eine perspektivische Ansicht der Fahrzeugbatterieschaltung 4 gemäß einer zweiten Ausführung und ihrer Stromsensoren 6 sowie eine Ausführungen der Stromsensoren 6 selbst zeigen.

Auf der Fahrzeugbatterieschaltung 4 gemäß Fig. 7 ist exemplarisch kein Temperatursensor 6 angeordnet.

Desweiteren sind die Bond-Bänder 70 in der vorliegenden Ausführung durch Stromsammelschienen 72 ersetzt, die dem Fachmann unter dem Begriff "Leadframe" bekannt sind.

Im Gegensatz zu den Fig. 3 und 5 überdeckt der faserverstärke Kunststoff 58 in der vorliegenden Ausführung beispielhaft die Oberfläche der gesamten Stromführleiterbahnen 40, 42, so dass in der vorliegenden Ausführung nur die erste der beiden Stromführleiterbahnen 40 zu sehen und daher mit einem Bezugszeichen versehen ist.

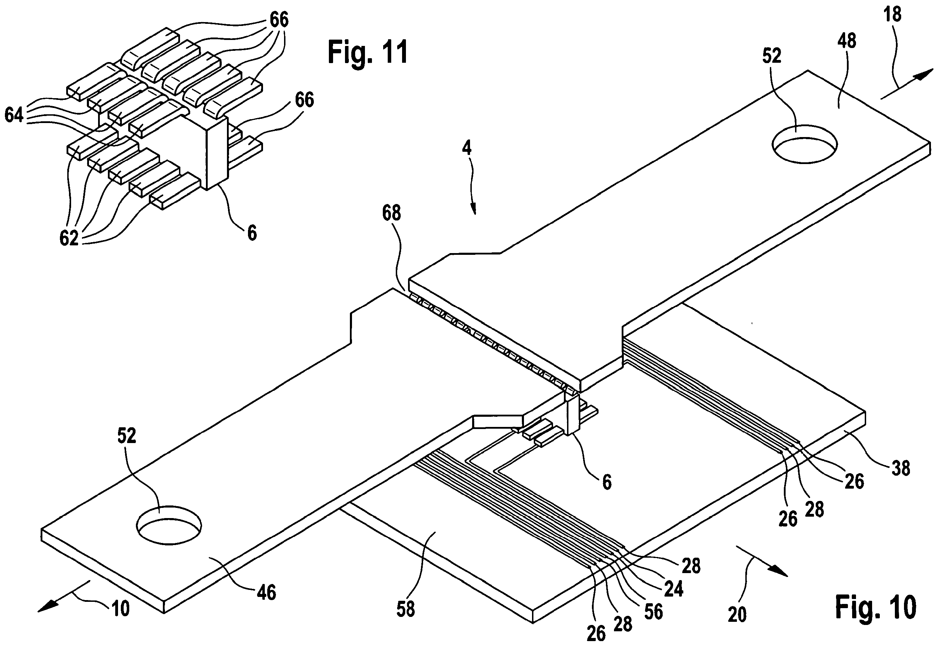

Es wird auf die Fig. 10 und 11 Bezug genommen, die entsprechend eine perspektivische Ansicht der Fahrzeugbatterieschaltung 4 gemäß einer vierten Ausführung und ihrer Stromsensoren 6 sowie eine Ausführung der Stromsensoren 6 selbst zeigen.

Der Stromsensor 6 im vorliegenden Ausführungsbeispiel ist als integrierte Schaltung aufgebaut. Das Schaltungsgehäuse dieser integrierten Schaltung ist in der vorliegenden Ausführung quaderförmig aufgebaut.

Die Fahrzeugbatterieschaltung 4 gemäß Fig. 1 benötigt an den Source-Anschlüssen 64 und den Drain-Anschlüssen 66 der Feldeffekttransistoren der Stromsensoren 6 zwei verschiedene Kontaktierungen. Eine erste Kontaktierung muss mit den Stromführleiterbahnen 40, 42 oder mit den Leiterbahnabschnitten 46, 48 selbst erfolgen, um den elektrischen Strom 12 zwischen der Fahrzeugbatterie 10 und dem Umschalter 18 zu leiten. Eine zweite Kontaktierung ist notwendig, um mit den Messleiterbahnen die Potentiale 24, 26 für den Spannungsabfall 22 zu erfassen und an die Auswerteschaltung 20 zu leiten.

In den vorangegangenen Ausführungsbeispielen erfolgten diese beiden Kontaktierung am als integrierte Schaltung oder als bare die ausgeführten Stromsensor 6 an einer gemeinsamen Stelle. In der vorliegenden Ausführung sollen die beiden Kontaktierungen an zwei geometrisch unterschiedlichen Stellen erfolgen. Dies hat den Vorteil, dass durch die Leiterplatte 38 keine Stromführleiterbahnen 40, 42 geführt werden brauchen, so dass die Leiterplatte 38 nicht als Hochstromleiterplatte ausgeführt werden muss, und somit günstiger hergestellt werden kann. Zudem kann in der vorliegenden Ausführung auf die prinzipbedingt schwächeren Bond-Bänder oder Bond-Drähte verzichtet werden.

Zudem werden die Leiterbahnabschnitte 46, 48 von der Leiterplatte 38 aus gesehen auf dem quaderförmigen Schaltungsgehäuse der integrierten Schaltung auf zwei gegenüberliegenden Mantelflächen elektrisch kontaktiert. Auf diese Weise kann die Leiterplatte 38 durch die Leiterbahnabschnitte 46, 48 über das Schaltungsgehäuse der integrierten Schaltung getragen werden, so dass keine weiteren Stabilisierungsmaßnahmen für die Leiterplatte 38 in der Fahrzeugbatterieschaltung 4 notwendig werden.

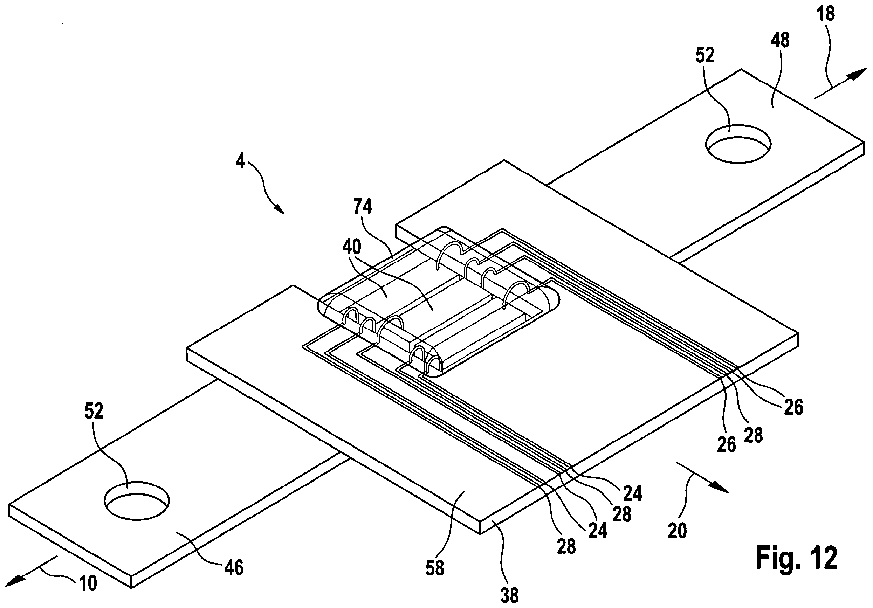

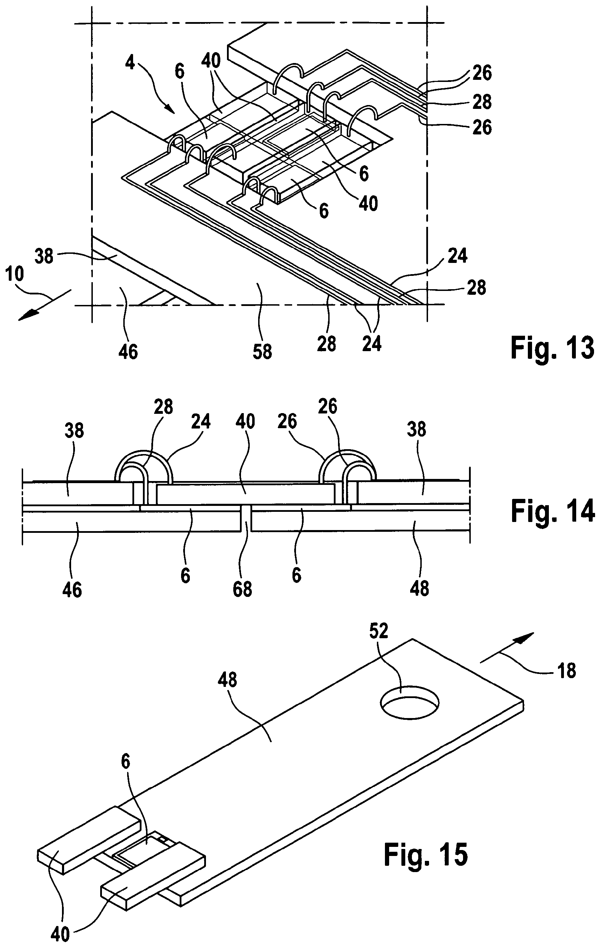

Es wird auf die Fig. 12 bis 15 Bezug genommen, die entsprechend eine perspektivische Ansicht einer Fahrzeugbatterieschaltung 4 gemäß einer fünften Ausführung, einen Ausschnitt aus der Darstellung gemäß Fig. 12, eine Seitenansicht der Fig. 13 und eine perspektivische Ansicht eines Leitungsabschnittes 48 mit einem darauf getragenen Stromsensor 6 und einer auf dem Stromsensor getragenen Stromführleiterbahn 40 der Fig. 12 zeigen.

In der vorliegenden Ausführung wurde wieder das Ziel verfolgt, die Leiterplatte 38 nicht als Hochstromleiterplatte ausführen zu müssen.

Dazu ist der für die Strommessung notwendige mechanische Spalt 68 zwischen den beiden Leitungsabschnitten 46, 48 mit ein Stromführleiterbahnen 40 überbrückt sind, die über dem Spalt 68 auf die beiden Leitungsabschnitte 46, 48 aufgelegt ist. Zwischen einem den Stromführleiterbahnen 40 und jeweils einem der Leitungsabschnitte 46, 48 sind die Stromsensoren 6 aus Fig. 6 so eingelegt, dass der Drain-Anschluss 66 der Stromsensoren 6 auf den Leitungsabschnitten 46, 48 aufliegt und der Source-Anschluss 64 mit einem der Stromführleiterbahnen 40 kontaktiert ist. Durch abwechselndes Anordnen der Stromsensoren 6 auf einem der Leitungsabschnitte 46, 48 in der zuvor genannten Weise kann die in Fig. 1 gezeigte antiparallele Verschaltung der Stromsensoren 6 in der Fahrzeugbatterieschaltung 4 erreicht werden.

Die Leiterplatte 38 weist in der vorliegenden Ausführung eine Aussparung auf, in der die Stromführleiterbahnen 40 aufgenommen werden. Auf der Leiterplatte 38 sind die Messleiterbahnen 24, 26, 28 geführt, die zur Übertragung des Steuersignals 28 mit dem Gate-Anschluss 62 des Stromsensors 6 und zur Erfassung der Potentiale 24, 26 mit dem Stromführleiterbahnen 40 und/oder mit den Leitungsabschnitten 46, 48 direkt elektrisch verbunden werden. Die elektrische Verbindung ist in der vorliegenden Ausführung beispielhaft mit nicht weiter referenzierten Bond-Bändern durchgeführt.

Auf diese Weise ist eine Integration der Stromführleiterbahnen 40 in die Leiterplatte 38 und somit ihre Ausführung als Hochstromleiterplatte nicht notwendig.

Mechanisch kann die Leiterplatte 38 auf dem Leitungsabschnitten 46, 48 und/oder an den Stromführleiterbahnen 40 in jeder beliebigen Weise, wie beispielsweise durch Verkleben, Verschrauben oder Vernieten befestigt werden.

Die Aussparung und die in der Aussparung aufgenommenen Stromführleiterbahnen 40 sowie die Stromsensoren 6 und die Bond-Bänder können zu ihrem Schutz vor Verschmutzung oder Nässe mit der Schutzmasse 74 bedeckt sein.

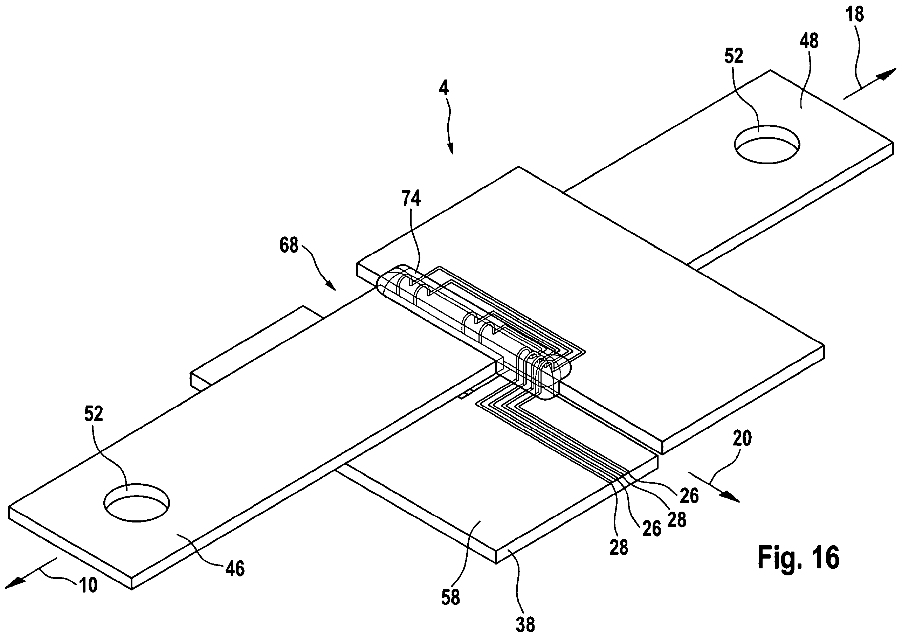

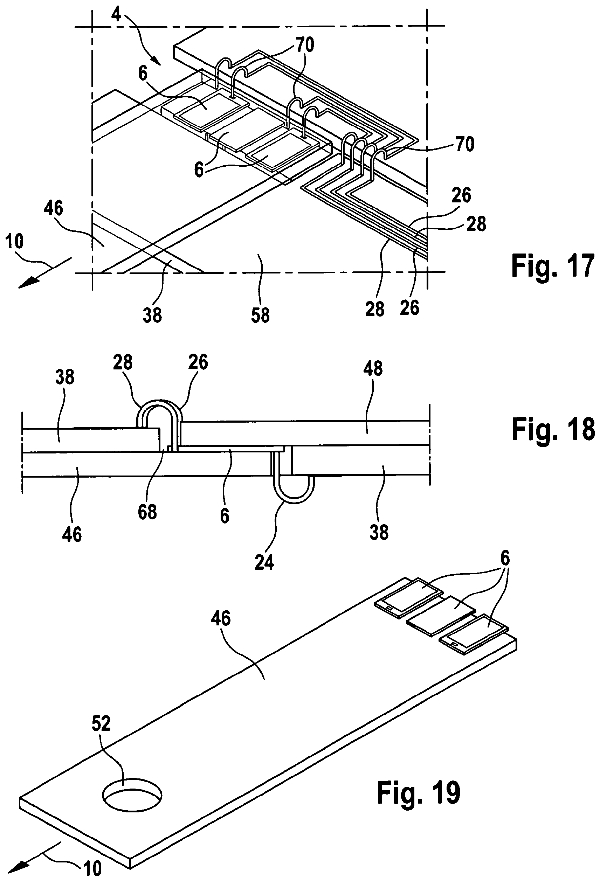

Es wird auf die Fig. 16 bis 19 Bezug genommen, die entsprechend eine perspektivische Ansicht einer Fahrzeugbatterieschaltung 4 gemäß einer sechsten Ausführung, einen Ausschnitt aus der Darstellung gemäß Fig. 16, eine Seitenansicht der Fig. 17 und eine perspektivische Ansicht eines Leitungsabschnittes 48 mit einem darauf getragenen Stromsensor 6 und einer auf dem Stromsensor getragenen Stromführleiterbahn 40 der Fig. 16 zeigen.

In der vorliegenden Ausführung sind die Leiterbahnabschnitte 46, 48 selbst in zwei verschiedenen Ebenen angeordnet, und überlappen sich an einem ihrer Enden. Dabei sind die Stromsensoren 6 aus Fig. 6 in dieser Überlappung zwischen den beiden Leiterbahnabschnitten 46, 48 aufgenommen und mit den Leiterbahnabschnitten 46, 48 elektrisch kontaktiert. Auf diese Weise sind weitere mechanische Elemente zum mechanischen Zusammenhalt der beiden Leiterbahnabschnitte 46, 48 obsolet.

Die Stromsensoren 6 sind auf den ersten Leiterbahnabschnitt 46 der beiden Leiterbahnabschnitte 46, 48 derart aufgelegt, dass immer abwechselnd einmal ein Stromsensor 6 mit seinem Source-Anschluss 64 und einmal ein Stromsensor 6 mit seinem Drain-Anschluss 66 aufgelegt wird. Auf diese Weise wird wieder die in Fig. 1 gezeigte antiparallele Verschaltung der Stromsensoren 6 erreicht.

Die Leiterplatte 38 muss in der vorliegenden Ausführung wieder nur die Messleiterbahnen 24, 26, 28 führen und daher nicht als Hochstromleiterplatte ausgeführt sein. Auch braucht sie keine mechanischen Kräfte zwischen den beiden Leiterbahnabschnitten 46, 48 aufzunehmen. Sie ist daher in zwei Teile aufgetrennt, wobei die beiden auf den Leiterplattenteilen getragenen Messleiterbahnen 24, 26, 28 über Bond-Bänder 70 miteinander elektrisch verbunden werden. Auch die elektrische Kontaktierung der in Fig. 6 gezeigten Gate-Anschlüsse 62 der Stromsensoren 6 zur Übertragung des Steuersignals 28 und die elektrische Kontaktierung der Leiterbahnabschnitte 46, 48 zur Erfassung der Potentiale 24, 26 für den Spannungsabfall 22 erfolgt in der vorliegenden Ausführung mit Bond-Bändern. Die Art der elektrischen Kontaktierung ist jedoch lediglich beispielhaft zu sehen.

Die Messleiterbahnen 24, 26, 28 verlaufen in der vorliegenden Ausführung prinzipbedingt auf der Oberseite und auf der Unterseite wenigstens eines der beiden Leiterplattenteile. Auf diesem Leiterplattenteil kann auch die Auswerteschaltung 20 getragen werden, wobei die Messleiterbahnen 24, 26, 28 einer Seite des entsprechenden Leiterplattenteils beispielsweise über Durchgangsbohrungen durch den Leiterplattenteil zu der Seite geführt werden können, auf der sich die Auswerteschaltung 20 befindet.

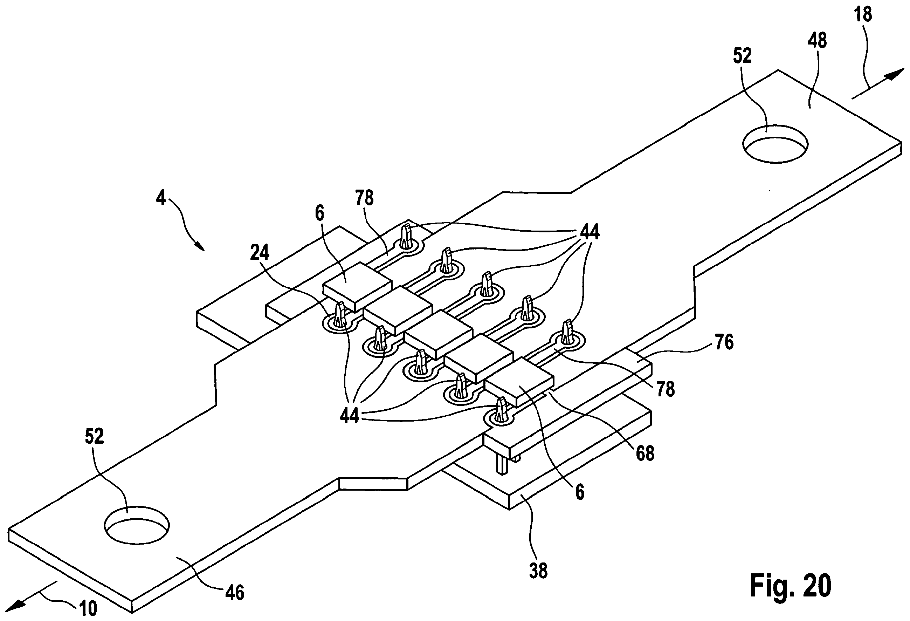

Es wird auf Fig. 20 Bezug genommen, die eine perspektivische Ansicht einer Fahrzeugbatterieschaltung 4 gemäß einer siebten Ausführung zeigt.

Im Rahmen der sieben Ausführungsform der Fahrzeugbatterieschaltung 4 werden die beiden Leiterbahnabschnitte 46, 48 über einen Tragerahmen 76 gegeneinander auf einem Abstand gehalten, der den Spalt 68 ausbildet. Dies ist in der vorliegenden Ausführung beispielhaft an zwei in der gleichen Ebene gehaltenen Leiterbahnabschnitten 46, 48 gezeigt. Der Spalt 68 wird wieder durch die Stromsensoren 6 überbrückt, die in der vorliegenden Ausführung als beispielhaft als integrierte Schaltungen ausgebildet sind.

Die Leiterbahnabschnitte 46, 48 werden über PressFit-Verbindungen 44 mit Messleiterbahnen zur Erfassung der Potentiale 24, 26 für den Spannungsabfall 22 auf einer Leiterplatte 38 kontaktiert. Mechanisch kann die Leiterplatte 38 dabei über die Pressfitverbindungen 44 an den Leiterbahnabschnitten 46, 48 gehalten werden. Die Steuersignale 28 zur Ansteuerung der Gates 62 der Stromsensoren 6 kann beispielsweise über nicht weiter dargestellte isolierte Durchgangsbohrungen durch eine der Leiterbahnabschnitte 46, 48 erfolgen, über die die Stromsensoren 6 mit entsprechenden Messleiterbahnen auf der Leiterplatte 38 elektrisch kontaktiert werden.

Die Leiterplatte 38 hier wieder nicht zwingend als Hochstromleiterplatte ausgeführt sein, da der den elektrischen Strom 12 zwischen der Fahrzeugbatterie 10 und dem Umschalter 18 leitende Strompfad über die beiden Leiterbahnabschnitte 46, 48 und die den Spalt 68 überbrückenden Stromsensoren 6 nicht über die Leiterplatte 38 geführt ist.

Der Trägerrahmen 76 sollte aus einem isolierenden Material aufgebaut sein, um die beiden Leiterbahnabschnitte 46, 48 nicht kurzzuschließen und elektrisch zu überbrücken. Dabei wird der Trägerrahmen 76 auf den PressFit-Anschlüssen 44 mechanisch getragen. Dabei weist der Trägerrahmen 76 an seiner Oberfläche, in die die Leiterbahnabschnitte 46, 48 eingelegt werden, Kanäle 78 auf, von denen in Fig. 20 der Übersichtlichkeit halber nur ein Teil mit einem Bezugszeichen versehen ist. In diesen Kanälen 78 werden die Leiterbahnabschnitte 46, 48 formschlüssig eingelegt, wobei die PressFit-Anschlüsse am den Stromsensoren 6 gegenüberliegenden Ende der Kanäle 78 die darin aufgenommenen Leiterbahnabschnitte 46, 48 durchstoßen. Auf diese Weise werden die Leiterbahnabschnitte 46, 48 über die formschlüssige Aufnahme in den Kanälen 78 des Trägerrahmens 76 und die Anbindung mit den PressFit-Anschlüssen 44 mechanisch im Trägerrahmen 76 fixiert und fest gehalten. Die Pressfit-Anschlüsse 44 dienen damit nicht nur wie bereits beschrieben zur elektrischen Kontaktierung der Leiterbahnabschnitte 46, 48 mit einer nicht weiter dargestellten Auswerteschaltung 20 auf der Leiterplatte 38 zur Erfassung des Spannungsabfalls 22 sondern auch zur mechanischen Stabilisierung der Leiterbahnabschnitte 46, 48 gegeneinander.

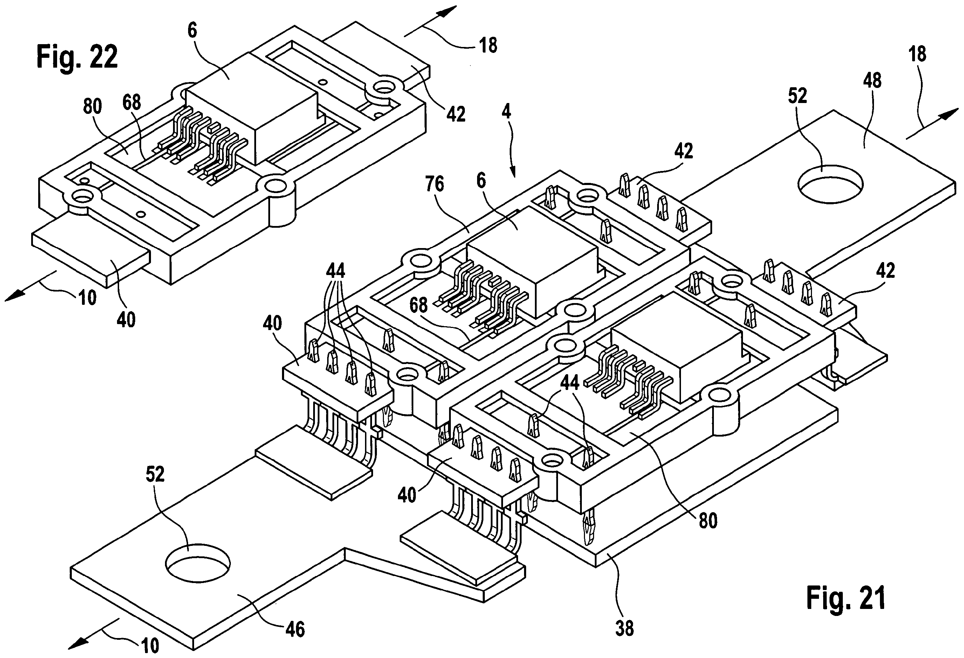

Es wird auf die Fig. 21 und 22 Bezug genommen, die entsprechend eine perspektivische Ansicht einer Fahrzeugbatterieschaltung 4 gemäß einer achten Ausführung und eine perspektivische Ansicht eines Stromsensors 6 aus der Fahrzeugbatterieschaltung 4 der Fig. 21 zeigen.

Die vorliegende Ausführung ist an die Ausführung gemäß Fig. 20 dahingehend angelehnt, dass die Teile des Stromweges für den elektrischen Strom 12, die an den Spalt 68 angrenzen, wieder über einen Trägerrahmen 76 gehalten und stabilisiert werden. Jedoch werden in der vorliegenden Ausführung nicht die Leiterbahnabschnitte 46, 48 im Trägerrahmen 76 gehalten, sondern die Stromführleiterbahnen 40, 42, die in derselben Weise über PressFit-Anschlüsse 44 mit den Leiterbahnabschnitten 46, 48 elektrisch verbunden werden können, wie in der Ausführung gemäß den Fig. 3 und 5.

In der vorliegenden Ausführung sind neben der ersten und zweiten Stromführleiterbahn 40, 42 noch eine dritte Stromführleiterbahn 80 in jedem Trägerrahmen 78 gehalten, die alle durch den Spalt 68 voneinander getrennt sind. Als Stromsensor 6 wird auf den Leiterbahnen 40, 42, 80 beispielhaft der Stromsensor 6 gemäß Fig. 4 getragen. Während der Source-Anschluss 64 mit der ersten Stromführleiterbahn 40 und der Drain-Anschluss 66 mit der zweiten Stromführleiterbahn 68 elektrisch kontaktiert ist, ist der Gate-Anschluss 62 mit der dritten Stromführleiterbahn 80 elektrisch kontaktiert. Auf diese Weise können die Anschlüsse des Stromsensors 6 über die Stromführleiterbahnen 40, 42, 80 und über PressFit-Verbindungen 44 in einfacher Weise mit zu einer nicht weiter dargestellten Auswerteschaltung 20 führenden und nicht weiter dargestellten Messleiterbahnen einer Leiterplatte 38 elektrisch kontaktiert werden, wobei die Leiterplatte 38 über die PressFit-Verbindungen 44 auch mechanisch gehalten wird.

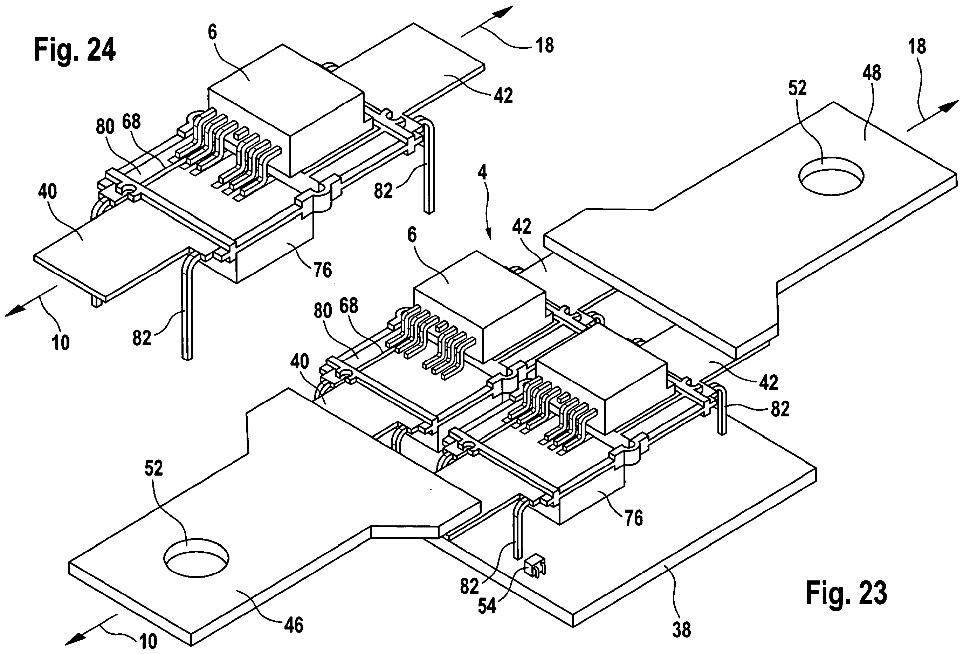

Es wird auf die Fig. 23 und 24 Bezug genommen, die entsprechend eine perspektivische Ansicht einer Fahrzeugbatterieschaltung 4 gemäß einer achten Ausführung und eine perspektivische Ansicht eines Stromsensors 6 aus der Fahrzeugbatterieschaltung 4 der Fig. 23 zeigen.

In Fig. 23 sind die Leiterbahnabschnitte 46, 48 direkt mit den Stromführleiterbahnen 40, 42, 80 beispielsweise durch Löten, Schweißen oder Leitkleben verbunden. Die Stromführleiterbahnen 40, 42, 80 weisen in der vorliegenden Ausführung ein Haltestifte 82 auf, die beispielsweise einstückig in die Stromführleiterbahnen 40, 42, 80 integriert oder beispielsweise per Presspassung an diesen befestigt sein können.

An den Haltestiften 82 kann eine Leiterplatte 38 befestigt sein, so dass auf der Leiterplatte 38 nicht weiter dargestellte Messleiterbahnen 24, 26, 28 über die Haltestifte 82 elektrisch kontaktiert werden können, um in der bereits genannten Weise Steuersignale 28 zu den Stromsensoren 6 und Potentiale 24, 26 zur Erfassung des Spannungsabfalls zu einer nicht gezeigten Auswerteschaltung 20 zu leiten.

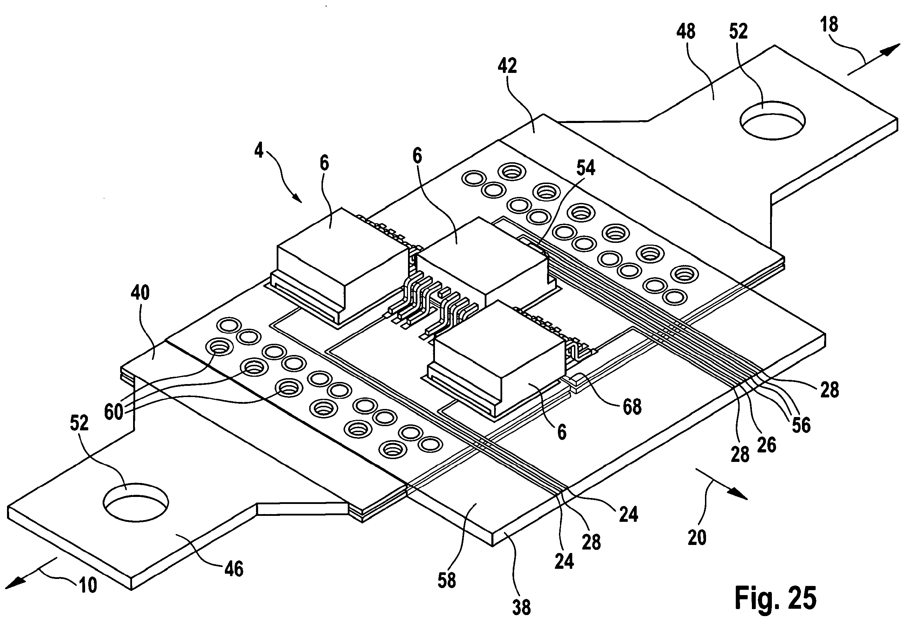

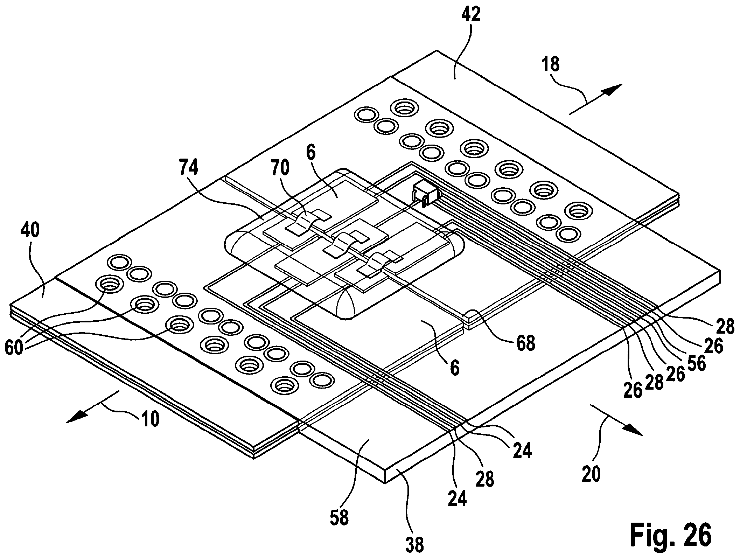

Es wird auf die Fig. 25 und 26 Bezug genommen, die entsprechend eine perspektivische Ansicht einer Fahrzeugbatterieschaltung 4 gemäß einer neunten Ausführung und eine perspektivische Ansicht eines alternativen Stromsensors 6 für die Fahrzeugbatterieschaltung 4 der Fig. 25 zeigen.

Das vorliegende Ausführungsbeispiel der Fahrzeugbatterieschaltung 4 ist eine alternative Ausführung zu den in Fig. 3 und 5 gezeigten Ausführungen. Hier ist die Hochstromleiterplatte 38 mit den Stromführleiterbahnen 40, 42 nicht mit über PressFit-Anschlüsse 44 mit den Leiterbahnabschnitten 40, 42 elektrisch und mechanisch kontaktiert, sondern wie ein passiver Shunt stirnflächig mit diesen verbunden. Nichtsdestotrotz liegt der eigentliche Stromsensor 6 außerhalb der Ebene der Leiterbahnabschnitte 46, 48, so dass eine eventuelle Wärmeausdehnung der Leiterbahnabschnitte 46, 48 ausschließlich mechanische Spannungen in die Stromführleiterbahnen 40, 42 und nicht in den Stromsensor 6 selbst einprägt.

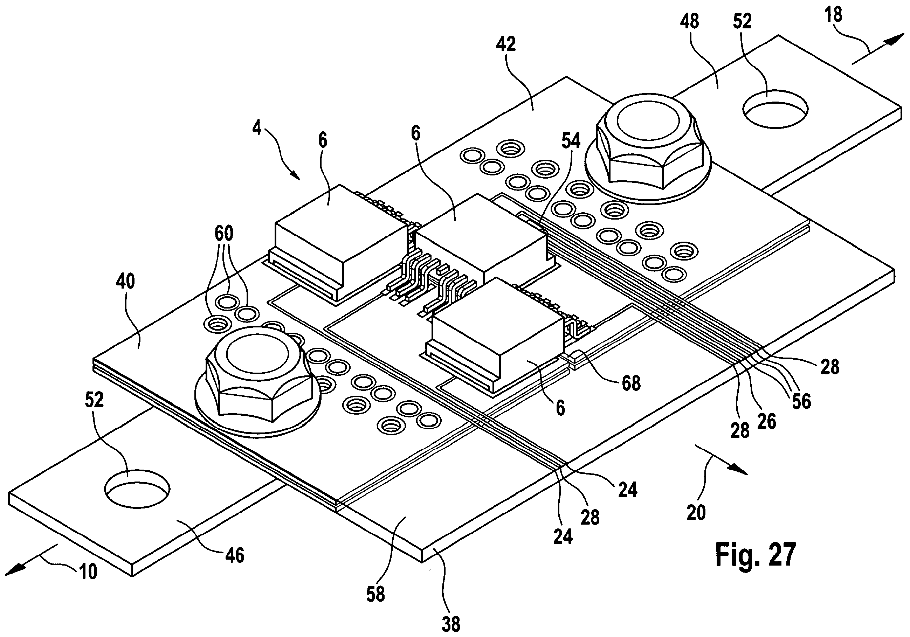

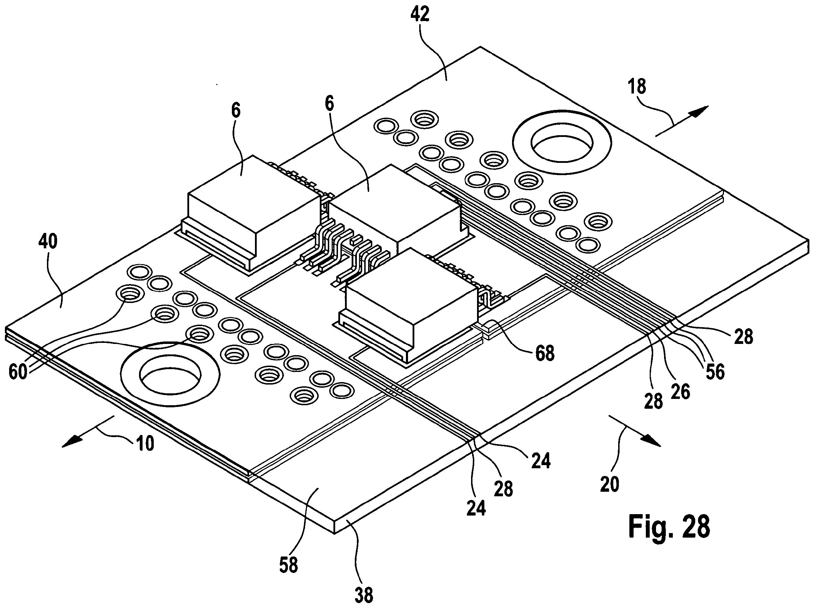

Es wird auf die Fig. 27 und 28 Bezug genommen, die entsprechend eine perspektivische Ansicht einer Fahrzeugbatterieschaltung 4 gemäß einer zehnten Ausführung und eine perspektivische Ansicht eines Stromsensors 6 aus der Fahrzeugbatterieschaltung 4 der Fig. 27 zeigen.

In der vorliegenden Ausführung ist die Hochstromleiterplatte 38 mit den Leiterbahnabschnitten 46, 48 verschraubt.

## Patentansprüche

1. Fahrzeugbatterieschaltung (4) zum Leiten eines elektrischen Stromes (12) zwischen einer Fahrzeugbatterie (10) und einer an die Fahrzeugbatterie (10) anschließbaren elektrischen Netzwerkkomponente (14, 16) , umfassend
- einen ersten flächenförmig verlaufenden elektrischen Leitungsabschnitt (46, 48) zum elektrischen Kontaktieren mit einem Pol (2) der Fahrzeugbatterie (10),
- einen vom ersten Leitungsabschnitt (46, 48) getrennten zweiten flächenförmig verlaufenden elektrischen Leitungsabschnitt (46, 48) zum elektrischen Kontaktieren mit der elektrischen Netzwerkkomponente (14, 16), und
- einen Stromsensor (6),
- wobei der Stromsensor (6) außerhalb des flächenförmigen Verlaufs wenigstens einer der Leitungsabschnitte (46, 48) angeordnet ist, **dadurch gekennzeichnet,**
**dass**
die Fahrzeugbatterieschaltung eine Leiterplatte (38) mit Messleiterbahnen (24, 26, 28), die den Stromsensor (6) mit einer Auswerteschaltung (20) elektrisch verbinden, umfasst, wobei
die Fahrzeugbatterieschaltung außerdem
Stromführleiterbahnen (40, 42), die den Stromsensor (6) mit den Leitungsabschnitten (46, 48) elektrisch kontaktieren, umfasst, wobei der Stromsensor (6) die Leitungsabschnitte (46, 48) miteinander elektrisch verbindet, so dass der elektrische Strom (12) zwischen der Fahrzeugbatterie (10) und der elektrischen Netzwerkkomponente (14, 16) über den Stromsensor (6) geleitet wird,
und wobei die Stromführleiterbahnen (40, 42) durch die Lei terplatte (38) geführt sind, die als Hochstromleiterplatte ausgebildet ist.

2. Fahrzeugbatterieschaltung (4) nach Anspruch 1, wobei die Leiterplatte (38) an den Leitungsabschnitten (46, 48) über eine mechanische Verbindung (44) gehalten ist.

3. Fahrzeugbatterieschaltung nach Anspruch 2, wobei die mechanische Verbindung über den Stromsensor geführt ist.

4. Fahrzeugbatterieschaltung (4) nach einem der Ansprüche 1 bis 3, wobei die Stromführleiterbahnen (40, 42) und/oder die Messleiterbahnen (24, 26, 28) an den Leitungsabschnitten (46, 48) über die mechanische Verbindung (44) gehalten sind.

5. Fahrzeugbatterieschaltung (4) nach einem der Ansprüche 2 bis 4, wobei die mechanische Verbindung (44) eine PressFit-Verbindung, eine Schraubverbindung, eine Lötverbindung, eine Leitklebverbindung und/oder eine Schweißverbindung ist.

6. Fahrzeugbatterieschaltung (4) nach einem der Ansprüche 1 bis 5, umfassend einen Trägerrahmen (76), in dem die Stromführleiterbahnen (40, 42) gehalten sind.

7. Fahrzeugbatterie (10) umfassend
- einen elektrischen Anschluss (2) zum Abgeben oder Aufnehmen eines elektrischen Stromes (12) an einen elektrischen Verbraucher (16) beziehungsweise von einer elektrischen Energiequelle (14), und
- eine Fahrzeugbatterieschaltung (4) nach einem der vorstehenden Ansprüche, die mit einem ihrer elektrischen Leitungsabschnitte (46, 48) an den elektrischen Anschluss (2) angeschlossen ist.

## Claims

1. Vehicle battery circuit (4) for conducting an electric current (12) between a vehicle battery (10) and an electrical network component (14, 16) that can be connected to the vehicle battery (10), comprising
- a first electrical conducting section (46, 48) that runs in an areal manner for the purpose of electrical contact-connection to a pole (2) of the vehicle battery (10),
- a second electrical conducting section (46, 48) that runs in an areal manner, which second electrical conducting section is isolated from the first conducting section (46, 48), for the purpose of electrical contact-connection to the electrical network component (14, 16), and
- a current sensor (6),
- wherein the current sensor (6) is arranged outside of the areal route of at least one of the conducting sections (46, 48), **characterized**
**in that**
the vehicle battery circuit comprises a printed circuit board (38) having measurement conductor tracks (24, 26, 28), which electrically connect the current sensor (6) to an evaluation circuit (20),
wherein
the vehicle battery circuit also comprises current-guiding conductor tracks (40, 42), which electrically contact-connect the current sensor (6) to the conducting sections (46, 48),
wherein the current sensor (6) electrically connects the conducting sections (46, 48) to one another so that the electric current (12) is conducted between the vehicle battery (10) and the electrical network component (14, 15) via the current sensor (6),
and wherein the current-guiding conductor tracks (40, 42) are guided through the printed circuit board (38), which is designed as a high-current printed circuit board.

2. Vehicle battery circuit (4) according to Claim 1, wherein the printed circuit board (38) is held on the conducting sections (46, 48) by means of a mechanical connection (44).

3. Vehicle battery circuit according to Claim 2, wherein the mechanical connection is guided via the current sensor.

4. Vehicle battery circuit (4) according to one of Claims 1 to 3, wherein the current-guiding conductor tracks (40, 42) and/or the measurement conductor tracks (24, 26, 28) are held on the conducting sections (46, 48) by means of the mechanical connection (44).

5. Vehicle battery circuit (4) according to one of Claims 2 to 4, wherein the mechanical connection (44) is a press-fit connection, a screw connection, a soldered connection, a conductive-adhesive connection and/or a welded connection.

6. Vehicle battery circuit (4) according to one of Claims 1 to 5, comprising a support frame (76), in which the current-guiding conductor tracks (40, 42) are held.

7. Vehicle battery (10) comprising
- an electrical terminal (2) for delivering or receiving an electric current (12) to an electrical load (16) or from an electrical energy source (14), and
- a vehicle battery circuit (4) according to one of the preceding claims, which is connected to the electrical terminal (2) by way of one of its electrical conducting sections (46, 48).

## Revendications

1. Circuit de batterie de véhicule (4) destiné à conduire un courant électrique (12) entre une batterie de véhicule (10) et un composant de réseau (14, 16) électrique pouvant être raccordé à la batterie de véhicule (10), comprenant
- une première portion de ligne électrique (46, 48) qui s'étend sous forme plane, servant à établir un contact électrique avec un pôle (2) de la batterie de véhicule (10),
- une deuxième portion de ligne électrique (46, 48), séparée de la première portion de ligne électrique (46, 48), qui s'étend sous forme plane et servant à établir un contact électrique avec le composant de réseau (14, 16) électrique, et
- un capteur de courant (6),
- le capteur de courant (6) étant disposé en-dehors du tracé sous forme plane d'au moins l'une des portions de ligne (46, 48), **caractérisé en ce que**
le circuit de batterie de véhicule comporte un circuit imprimé (38) doté de pistes conductrices de mesure (24, 26, 28) qui relient électriquement le capteur de courant (6) à un circuit d'interprétation (20),
le circuit de batterie de véhicule comportant en outre des pistes conductrices de guidage du courant (40, 42) qui mettent en contact électrique le capteur de courant (6) avec les portions de ligne (46, 48),
le capteur de courant (6) reliant les portions de ligne (46, 48) l'une à l'autre de telle sorte que le courant électrique (12) entre la batterie de véhicule (10) et le composant de réseau (14, 16) électrique est conduit par le biais du capteur de courant (6),
et les pistes conductrices de guidage du courant (40, 42) passant par le circuit imprimé (38), lequel est réalisé sous la forme d'un circuit imprimé à haute tension.

2. Circuit de batterie de véhicule (4) selon la revendication 1, le circuit imprimé (38) étant maintenu au niveau des portions de ligne (46, 48) par le biais d'une liaison mécanique (44).

3. Circuit de batterie de véhicule selon la revendication 2, la liaison mécanique passant par le capteur de courant.

4. Circuit de batterie de véhicule (4) selon l'une des revendications 1 à 3, les pistes conductrices de guidage du courant (40, 42) et/ou les pistes conductrices de mesure (24, 26, 28) étant maintenues au niveau des portions de ligne (46, 48) par le biais de la liaison mécanique (44).

5. Circuit de batterie de véhicule (4) selon l'une des revendications 2 à 4, la liaison mécanique (44) étant une liaison à emmanchement par force, une liaison par vissage, une liaison brasée, une liaison par colle conductrice et/ou une liaison soudée.

6. Circuit de batterie de véhicule (4) selon l'une des revendications 1 à 5, comprenant un cadre porteur (76) dans lequel sont maintenues les pistes conductrices de guidage du courant (40, 42).

7. Batterie de véhicule (10) comprenant
- une borne électrique (2) destinée à délivrer ou à recevoir un courant électrique (12) à un récepteur électrique (16) ou de la part d'une source d'énergie électrique (14), et
- un circuit de batterie de véhicule (4) selon l'une des revendications précédentes, lequel est raccordé à la borne électrique (2) par l'une de ses portions de ligne électrique (46, 48).
